# EUROPÄISCHE PATENTSCHRIFT

(11) **EP 3 478 531 B1**
(45) Veröffentlichungstag und Bekanntmachung des Hinweises auf die Patenterteilung: **09.12.2020**
(21) Anmeldenummer: 17731118.0
(22) Anmeldetag: 13.06.2017
(51) Int. Cl.: H01R 13/66, B60L 53/16

(54) **ELEKTROANSCHLUSSEINRICHTUNG MIT THERMISCHER KOPPLUNG EINER EINEN TEMPERATURSENSOR AUFWEISENDEN PLATINE**
ELECTRICAL CONNECTION ARRANGEMENT WITH THERMAL COUPLING OF A PRINTED CIRCUIT BOARD EMPLOYING A TEMPERATUR SENSOR
RACCORD ÉLECTRIQUE AVEC COUPLAGE THERMIQUE D'UN CIRCUIT IMPRIMÉ AYANT UN CAPTEUR DE TEMPÉRATURE

(30) Priorität: 30.06.2016 DE 102016211876
(43) Veröffentlichungstag der Anmeldung: 08.05.2019
(73) Patentinhaber: Phoenix Contact e-Mobility GmbH, 32816 Schieder-Schwalenberg (DE)
(72) Erfinder: FELDNER, Ralf, 32760 Detmold (DE); GARTH, Carsten, 32657 Lemgo (DE); GEBHARDT, Tanja, 33189 Schlangen (DE)
(74) Vertreter: Richly & Ritschel Patentanwälte PartG mbB
(86) Internationale Anmeldenummer: PCT/EP2017/064373
(87) Internationale Veröffentlichungsnummer: WO 2018/001719

(56) Entgegenhaltungen:
- WO-A1-2015/044068
- US-A- 5 181 859

## Beschreibung

Die vorliegende Erfindung betrifft eine Elektroanschlusseinrichtung zur Kopplung mit einer korrespondierenden Verbindungsvorrichtung und zur Übertragung elektrischer Energie. Ferner betrifft die vorliegende Erfindung eine Ladestation zur Abgabe elektrischer Energie an einen Empfänger elektrischer Energie.

Aus dem Stand der Technik sind als Steckverbinder bzw. als Ladestecker ausgebildete Elektroanschlusseinrichtungen für elektrisch antreibbare Fahrzeuge bekannt, die zur Verbindung mit einer korrespondierenden als Buchse ausgebildeten Verbindungsvorrichtung ausgebildet sind. Diesbezüglich wird auf den in der DE 10 2012 105 774 B3 offenbarten Ladestecker verwiesen. In dem Ladestecker sind Leistungskontakte angeordnet, die jeweils einen ersten Anschlussbereich und einen zweiten Anschlussbereich aufweisen. Der erste Anschlussbereich ist als Kontaktbuchse ausgebildet und zur galvanischen Verbindung mit einem Kontaktstift geeignet, wobei der Kontaktstift mit einem elektrischen Energieempfänger, beispielsweise einem Akkumulator eines Fahrzeuges galvanisch verbundenen ist. Es gibt jedoch auch eine mögliche Konstellation, in der eine Kontaktbuchse mit dem Akkumulator verbunden ist, wobei in diesem Fall der erste Anschlussbereich dann als Kontaktstift ausgebildet ist. Der zweite Anschlussbereich des Leistungskontakts ist zur galvanischen Verbindung mit einer elektrischen Energiequelle, beispielsweise eine Ladestation oder im Allgemeinen mit einem elektrischen Versorgungsnetz ausgebildet. Zu diesem Zweck ist der zweite Anschlussbereich mit einer Ladeleitung fest verbunden.

Aufgrund eines durch den Leistungskontakt fließenden Ladestroms heizt sich der Leistungskontakt unweigerlich aufgrund von ohmschen Stromwärmeverlusten auf. Das Aufheizen des Leistungskontakts ist jedoch auf eine Grenztemperaturerhöhung limitiert. So ist beispielsweise gemäß der Norm IEC 62196-3 die Grenztemperaturerhöhung auf 50K limitiert. Dies wiederum führt bei größtenteils genormten Steckverbindergeometrien zu einem maximalen Ladestrom von bis zu 200 A Dauerlast.

Bei einer intermittierenden Aufladung eines Akkumulators sind hingegen höhere Ladeströme von 350 A und mehr über begrenzte Zeiträume notwendig, um den Akkumulator in einer gewünscht kurzen Zeit aufzuladen. Dies wiederum führt zu einer temporären Erhitzung der Leistungskontakte, die über der Grenztemperaturerhöhung liegt.

Um ein Überhitzen der Steckverbinder zu vermeiden, ist es aus dem Stand der Technik bekannt, Steckverbinder mit Temperatursensoren zu versehen. Diese überwachen die Temperatur des Steckverbinders. Sobald die Temperatur einen definierten Grenzwert überschreitet, wird mittels einer Überwachungselektronik der Ladevorgang unterbrochen oder der Ladestrom reduziert.

So beschreibt die DE 10 2009 034 886 A1 eine Steckvorrichtung für ein Ladekabel zur Verbindung eines Elektrofahrzeuges mit einer Ladestation. Dabei umfasst die Steckvorrichtung ein Gehäuse und dem Gehäuse zugeordnete elektrische Kontakte zum Anschluss an eine Anschlusseinrichtung in der Ladestation oder in dem Elektrofahrzeug. Zudem ist in dem Gehäuse ein als Thermistor ausgebildetes Temperaturerfassungsmittel vorgesehen, wobei über das Temperaturerfassungsmittel die Temperatur im Gehäuse auswertbar ist. WO 2015/044068 A1 offenbart ein Steckverbinderteil, mit einer Widerstandskodierung, über welche der maximal zulässige Ladestrom des angeschlossenen Ladekabels oder der angeschlossenen Ladeeinrichtung eines Elektrofahrzeugs ermittelt werden soll. US 5 181 859 A offenbart eine Vorrichtung zum Herstellen einer elektrischen Verbindung mit einer Mehrzahl von Stiften in einem Stecker.

Aus produktionstechnischen Gründen und zur Integration bzw. Zusammenfassung mehrerer Funktionalitäten ist es wünschenswert, in der Elektroanschlusseinrichtung eine Platine vorzusehen, die mit zumindest einem Leistungskontakt, vorzugsweise mit mehreren Leistungskontakten thermisch und gegebenenfalls auch elektrisch verbunden ist. Aufgrund von Dickentoleranzen der zu verbauenden Platinen ist eine thermische Kopplung und gegebenenfalls eine elektrische Verbindung einer Platine mit den Leistungskontakten jedoch nicht immer zuverlässig möglich, insbesondere wenn eine Platine senkrecht zu einer Steckrichtung der Elektroanschlusseinrichtung orientiert ist, wenn also eine Flächennormale der Platine parallel zu einer Steckrichtung der Elektroanschlusseinrichtung und damit parallel zu einer Längsachse des Leistungskontakts ausgerichtet ist.

Der vorliegenden Erfindung liegt die Aufgabe zugrunde, eine Elektroanschlusseinrichtung bereitzustellen, bei der eine zuverlässige thermische Kopplung der Platine mit zumindest einem Leistungskontakt gewährleistet ist.

Die der vorliegenden Erfindung zugrundeliegende Aufgabe wird durch eine Elektroanschlusseinrichtung mit den Merkmalen des Anspruchs 1 gelöst. Vorteilhafte Ausgestaltungen der Elektroanschlusseinrichtung sind in den von Anspruch 1 abhängigen Ansprüchen beschrieben.

Im Genaueren wird die der vorliegenden Erfindung zugrundeliegende Aufgabe durch eine Elektroanschlusseinrichtung zur Kopplung mit einer korrespondierenden Verbindungsvorrichtung und zur Übertragung elektrischer Energie gelöst, wobei die Elektroanschlusseinrichtung zumindest einen in einem Gehäuse der Elektroanschlusseinrichtung angeordneten und mit diesem verbundenen Leistungskontakt und zumindest einen Temperatursensor zum Bestimmen einer Temperatur des Leistungskontakts aufweist. Die erfindungsgemäße Elektroanschlusseinrichtung ist dadurch gekennzeichnet, dass diese eine in deren Gehäuse angeordnete Platine aufweist, die zwischen dem Leistungskontakt und einem Halteabschnitt des Gehäuses angeordnet ist, wobei die Platine mittels einer zwischen dem Leistungskontakt und dem Halteabschnitt angeordneten Federkrafteinrichtung zwischen dem Leistungskontakt und dem Halteabschnitt verspannt ist. Die Platine ist mit dem Leistungskontakt direkt oder über die Federkrafteinrichtung thermisch gekoppelt, und der zumindest eine Temperatursensor ist auf der Platine angeordnet.

Bei der erfindungsgemäßen Elektroanschlusseinrichtung ist ein zuverlässiger entweder direkter oder über die Federkrafteinrichtung vermittelter Kontakt der Platine mit dem Leistungskontakt gewährleistet. Somit können Dickentoleranzen der zu verbauenden Platinen zuverlässig ausgeglichen werden. Ferner weist die erfindungsgemäße Elektroanschlusseinrichtung eine vereinfachte Montage auf, da die Platine in der Elektroanschlusseinrichtung schwimmend montiert werden kann, so dass bei der Positionierung der Platine innerhalb der Elektroanschlusseinrichtung nicht so hohe Maßstäbe angesetzt werden müssen, wobei gleichzeitig eine zuverlässige Kontaktierung der Platine gewährleistet bleibt.

Die Elektroanschlusseinrichtung kann als Ladestecker und/oder als Ladebuchse ausgebildet sein. Wenn die Elektroanschlusseinrichtung als Ladestecker ausgebildet ist, dann ist das Gehäuse der Elektroanschlusseinrichtung als Ladesteckergehäuse ausgebildet. Wenn die Elektroanschlusseinrichtung als Ladebuchse ausgebildet ist, dann ist das Gehäuse der Elektroanschlusseinrichtung als Ladebuchsengehäuse ausgebildet.

Die mechanische Kopplung der Platine mit dem Leistungskontakt bedeutet, dass entweder die Federkrafteinrichtung mit dem Leistungskontakt oder die Platine selber mit dem Leistungskontakt in direktem Kontakt steht.

Die Federkrafteinrichtung ist vorzugsweise als ein gebogenes Metallband ausgebildet. Beispielsweise kann die Federkrafteinrichtung aus Federstahl gebildet sein. Im Querschnitt kann die Federkrafteinrichtung beispielsweise U- oder S-förmig ausgebildet sein.

Die Federkrafteinrichtung kann den Leistungskontakt in eine zu einer Längsachse des Leistungskontakts parallele Richtung und/oder eine zur Längsachse des Leistungskontakts radiale Richtung kraftbeaufschlagen.

Wenn der Ladestecker mehr als einen Temperatursensor umfasst, können selbstverständlich sämtliche Temperatursensoren auf der Platine angeordnet sein.

Vorzugsweise ist die die Elektroanschlusseinrichtung derart ausgebildet, dass die Platine mit dem Leistungskontakt direkt oder über die Federkrafteinrichtung galvanisch verbunden ist.

Die entsprechend ausgebildete Elektroanschlusseinrichtung weist eine nochmals verbesserte thermische Kopplung zwischen der Platine und dem Leistungskontakt aus. Ferner bietet die entsprechend ausgebildete Elektroanschlusseinrichtung den Vorteil, dass aufgrund der galvanischen Verbindung der Platine mit dem Leistungskontakt der Leistungskontakt mittels der Platine beispielsweise widerstandscodiert werden kann. Ferner können zwischen der Platine und dem Leistungskontakt Informationen ausgetauscht werden.

Vorzugsweise ist die Elektroanschlusseinrichtung derart ausgebildet, dass die Platine eine elektrisch leitend ausgebildete Kontaktfläche aufweist, die mit dem Leistungskontakt direkt oder über die Federkrafteinrichtung galvanisch verbunden ist.

Dabei ist die elektrisch leitend ausgebildete Kontaktfläche vorzugsweise aus einem Metall gebildet oder weist zumindest einen metallischen Bestandteil auf.

Weiter vorzugsweise ist die Elektroanschlusseinrichtung derart ausgebildet, dass die Federkrafteinrichtung als oberflächenmontierte Federkrafteinrichtung ausgebildet und mit der Kontaktfläche verlötet ist.

Eine entsprechend ausgebildete Elektroanschlusseinrichtung weist eine nochmals vereinfachte Montage auf, da die Federkrafteinrichtung fest mit der Platine verbunden ist, so dass die Federkrafteinrichtung bei der Montage der Elektroanschlusseinrichtung nicht gesondert positioniert werden muss. Ferner ist bei der entsprechend ausgebildeten Elektroanschlusseinrichtung stetes eine zuverlässige sowohl mechanische als auch galvanische Verbindung der Federkrafteinrichtung mit der Platine gewährleistet.

Die oberflächenmontierte Federkrafteinrichtung kann auch als SMD-Federkrafteinrichtung bezeichnet werden. SMD steht dabei für surface-mount device. Die Federkrafteinrichtung wird auf die Kontaktfläche der Platine direkt gelötet. Die dazugehörige Technik wird als Oberflächenmontage bezeichnet.

Gemäß einer vorteilhaften Ausführung ist die Elektroanschlusseinrichtung derart ausgebildet, dass die Platine eine Durchgangsöffnung aufweist, durch die der Leistungskontakt hindurchragt und die Kontaktfläche der Platine deren Durchgangsöffnung umschließt.

Die entsprechend ausgebildete Elektroanschlusseinrichtung weist nochmals verbesserte Montageeigenschaften auf, da eine radiale Positionierung der Platine, also eine Positionierung senkrecht zu einer Steckrichtung der Elektroanschlusseinrichtung, durch den Leistungskontakt / die Leistungskontakte erfolgt.

Der Leistungskontakt weist einen ersten Anschlussbereich zur galvanischen Verbindung mit einem elektrischen Energieempfänger oder Energiesender und einen zweiten Anschlussbereich zur galvanischen Verbindung mit einer Ladeleitung auf. Vorzugsweise durchragt der erste Anschlussbereich des Leistungskontakts die Durchgangsöffnung der Platine.

Gemäß einer weiteren vorteilhaften Ausführung ist die Elektroanschlusseinrichtung derart ausgebildet, dass die Federkrafteinrichtung mit dem Leistungskontakt und der Platine galvanisch verbunden ist, wobei die Platine mittels der Federkrafteinrichtung gegen den Halteabschnitt verspannt ist.

Die Federkrafteinrichtung ist folglich elektrisch leitend ausgebildet. Beispielsweise kann die Federkrafteinrichtung aus einem Stahl, vorzugsweise aus einem Federstahl gebildet sein. Folglich ist die Platine mittels der Federkrafteinrichtung in Richtung des Halteabschnitts kraftbeaufschlagt.

Weiter vorzugsweise ist die Elektroanschlusseinrichtung derart ausgebildet, dass der Leistungskontakt einen Befestigungsflansch aufweist, mittels dem der Leistungskontakt mit dem Ladesteckergehäuse verbunden ist, wobei sich der Befestigungsflansch radial von einer Längsachse des Leistungskontakts weg erstreckt. Weiter vorzugsweise ist die Elektroanschlusseinrichtung derart ausgebildet, dass die Federkrafteinrichtung zwischen dem Befestigungsflansch und dem Halteabschnitt des Gehäuses angeordnet ist.

Durch eine entsprechende Ausbildung der Elektroanschlusseinrichtung wird zuverlässig eine sowohl mechanische als auch galvanische Kontaktierung des Leistungskontakts entweder durch die Platine direkt oder durch die Federkrafteinrichtung erreicht.

Gemäß einer vorteilhaften Ausführung der Elektroanschlusseinrichtung wird die Platine zur Widerstandscodierung des Leistungskontakts verwendet.

Bei der entsprechend ausgebildeten Elektroanschlusseinrichtung werden verschiedene Funktionalitäten, nämlich die Widerstandscodierung des Leistungskontakts und die Temperaturbestimmung des Leistungskontakts durch ein einziges Bauteil, nämlich die Platine, realisiert. Somit weist die entsprechend ausgebildete Elektroanschlusseinrichtung weniger Bauteile auf, wodurch sich sowohl deren Herstellungskosten als auch der Montageaufwand reduzieren.

Die Widerstandscodierung kann mittels einem auf der Platine angeordneten Codierungsmittel für den Wert der über das Ladekabel übertragbaren Stromstärke erfolgen. Das Codierungsmittel kann insbesondere als ohmscher Widerstand ausgebildet sein.

Ein vom Fahrzeugnutzer verwendete Ladekabel weist einen bestimmten Kupferquerschnitt seiner Kabelleitungen auf, wodurch die maximal zulässige elektrische Stromstärke definiert ist, die über das Ladekabel fließen kann. Zur Kodierung, d.h. Festlegung, dieses Wertes weist das Ladekabel im Bereich zumindest eines seiner beiden Stecker einen ohmschen Widerstand auf, dessen Nennwert der zulässigen Stromstärke eindeutig zugeordnet ist. Jedem für ein Ladekabel jeweils zulässigen Nennstromstärkewert, zum Beispiel 16 A, 32 A, oder 63 A, entspricht dabei ein bestimmter ohmsche Widerstandswert.

Gemäß einer weiteren vorteilhaften Ausführungsform der Elektroanschlusseinrichtung ist eine Flächennormale der Platine im Wesentlichen parallel zu einer Längsachse des Leistungskontakts ausgerichtet.

Die entsprechend ausgebildete Elektroanschlusseinrichtung weist vorteilhafte Montageeigenschaften auf. Ferner wird eine zuverlässige sowohl mechanische als auch galvanische Kontaktierung zwischen dem Leistungskontakt und der Platine bzw. der Federkrafteinrichtung erreicht.

Das Merkmal, wonach die Flächennormale parallel zur Längsachse des Leistungskontakts ausgerichtet ist, hat zur Folge, dass die Flächennormale der Platine parallel zur einer Steckrichtung der Elektroanschlusseinrichtung ausgerichtet ist. Die Elektroanschlusseinrichtung wird durch Einschieben in Steckrichtung mit der Verbindungsvorrichtung mechanisch und elektrisch gekoppelt.

Erfindungsgemäß ist die Elektroanschlusseinrichtung derart ausgebildet, dass das Gehäuse einen frontseitigen Bereich und einen mit diesem verbindbaren rückseitigen Bereich aufweist, wobei der Leistungskontakt im rückseitigen Bereich angeordnet und mit diesem verbunden ist, wobei der Halteabschnitt des Gehäuses im frontseitigen Bereich angeordnet ist, und wobei die Platine zwischen dem rückseitigen Bereich und dem frontseitigen Bereich angeordnet ist.

Die entsprechend ausgebildete Elektroanschlusseinrichtung ist besonders einfach zu montieren.

Vorzugsweise ist die Elektroanschlusseinrichtung derart ausgebildet, dass der Temperatursensor ein temperaturabhängiger elektrischer Widerstand, insbesondere ein Thermistor ist.

Alternativ kann der Temperatursensor auch als NTC-Widerstand (Heißleiter), PTC-Widerstand (Kaltleiter) oder als KTY-Sensor ausgebildet sein.

Die der vorliegenden Erfindung zugrundeliegende Aufgabe wird ferner durch eine Ladestation zur Abgabe elektrischer Energie an einen Empfänger elektrischer Energie gelöst, wobei die Ladestation eine oben beschriebene als Ladestecker ausgebildete Elektroanschlusseinrichtung aufweist, die mit der Ladestation mittels eines Versorgungskabels elektrisch verbunden ist.

Weitere Vorteile, Einzelheiten und Merkmale der Erfindung ergeben sich nachfolgend aus den erläuterten Ausführungsbeispielen. Dabei zeigen im Einzelnen:
- Figur 1A:: eine perspektivische Darstellung einer als Ladestecker ausgebildeten erfindungsgemäßen Elektroanschlusseinrichtung von schräg vorne betrachtet mit demontiertem rückseitigen Bereich;
- Figur 1B:: eine perspektivische Darstellung des frontseitigen Bereichs des in Figur 1A dargestellten Ladesteckers;
- Figur 2A:: eine Draufsicht auf das Steckgesicht des erfindungsgemäßen Ladesteckers;
- Figur 2B:: eine Querschnittsdarstellung des in Figur 2A dargestellten Ladesteckers entlang der Schnittebene K-K;
- Figur 2C:: eine Detailansicht der in Figur 2B dargestellten Querschnittsdarstellung;
- Figur 3A:: das in Figur 2A dargestellte Steckgesicht mit einer anderen Schnittebene;
- Figur 3B:: eine Querschnittsdarstellung durch den in Figur 3A dargestellten Ladestecker entlang der Schnittebene K-K;
- Figur 3C:: ein Leistungskontakt zusammen mit dem einer mit diesem gekoppelter Platine des erfindungsgemäßen Ladesteckers in seitlicher Querschnittsdarstellung;
- Figur 4A:: eine Querschnittsdarstellung zweier Leistungskontakte mit einer mit beiden gekoppelter Platine des erfindungsgemäßen Ladesteckers in perspektivischer Darstellung;
- Figur 4B:: das in Figur 4A dargestellte System aus einer anderen Perspektive; und
- Figur 4C:: eine perspektivische Darstellung einer Platine des erfindungsgemäßen Ladesteckers in Alleinstellung.

In der nun folgenden Beschreibung bezeichnen gleiche Bezugszeichen gleiche Bauteile beziehungsweise gleiche Merkmale, so dass eine in Bezug auf eine Figur durchgeführte Beschreibung bezüglich eines Bauteils auch für die anderen Figuren gilt, so dass eine wiederholende Beschreibung vermieden wird. Ferner sind einzelne Merkmale, die in Zusammenhang mit einer Ausführungsform beschrieben wurden, auch separat in anderen Ausführungsformen verwendbar.

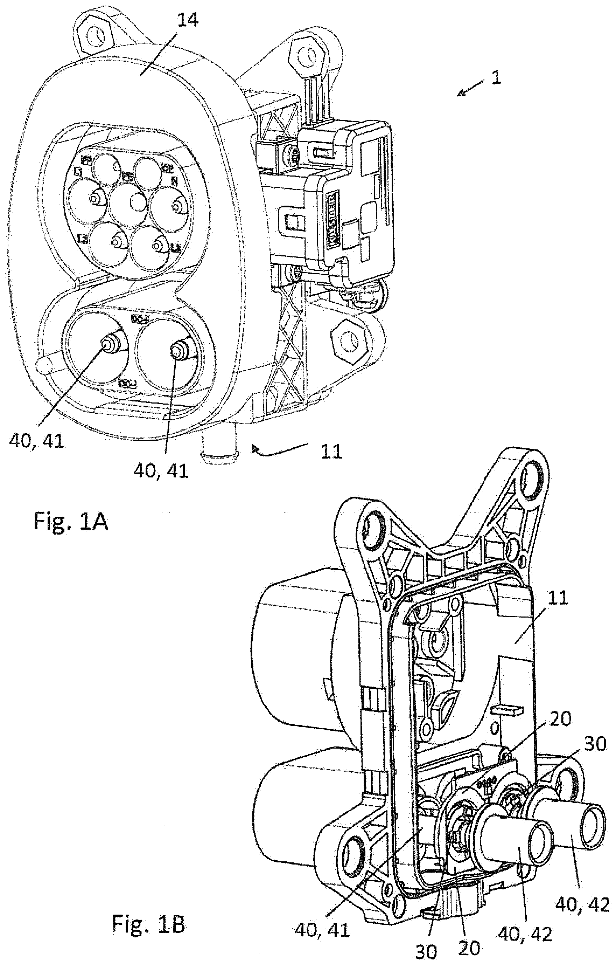

In den Figuren 1A und 1B ist eine erfindungsgemäße Elektroanschlusseinrichtung 1 dargestellt, die in dem dargestellten Ausführungsbeispiel als Ladestecker 1 ausgebildet ist. Der Ladestecker 1 ist zur Kopplung mit einer korrespondierenden Verbindungsvorrichtung und zur Übertragung elektrischer Energie ausgebildet. Eine entsprechende Verbindungsvorrichtung kann beispielsweise eine in den Figuren nicht dargestellte Ladebuchse eines Kraftfahrzeugs sein, die mit einem Akkumulator verbunden ist.

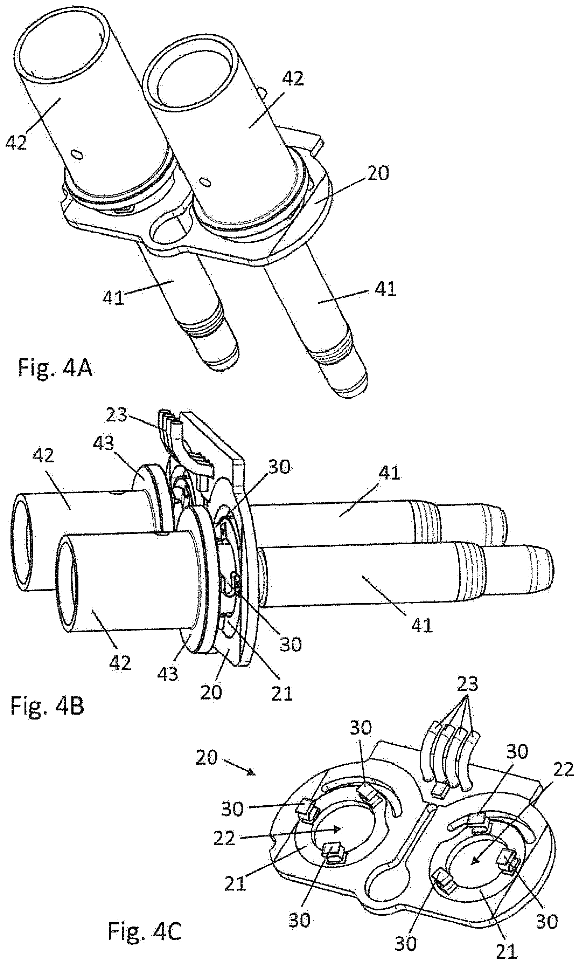

Der in den Figuren dargestellte Ladestecker 1 umfasst zwei Leistungskontakte 40, die zu Übertragung von Gleichstrom ausgebildet sind. Die Leistungskontakte 40 sind in den Figuren 4A und 4B klarer ersichtlich. Die Leistungskontakte 40 weisen einen ersten Anschlussbereich 41 zum Koppeln mit einem Energieempfänger (beispielsweise eine Kontaktbuchse eines Elektrofahrzeugs) und einen zweiten Anschlussbereich 42 auf, der mittels einer Ladeleitung beispielsweise mit einer in den Figuren nicht dargestellten Ladestation elektrisch verbindbar ist. Die ersten Anschlussbereiche 41 der Leistungskontakte 40 sind als Kontaktstifte 41 ausgebildet.

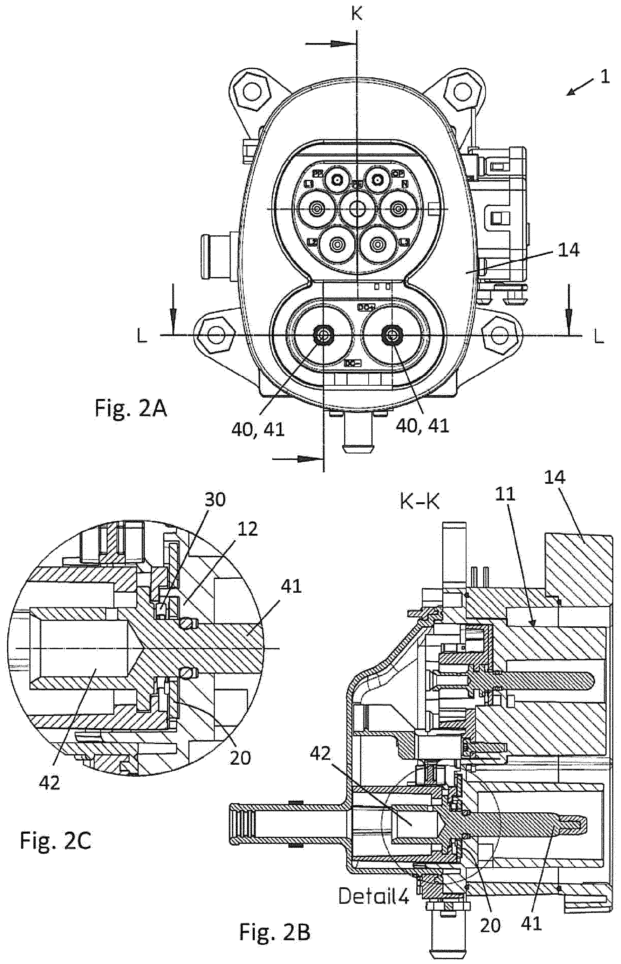

Der Ladestecker 1 weist ein Gehäuse 10 auf, dass in dem dargestellten Ausführungsbeispiel als Ladesteckergehäuse 10 ausgebildet ist. Das Ladesteckergehäuse 10 weist einen frontseitigen Bereich 11 und einen rückseitigen Bereich 13 auf (siehe Figur 2B). Aus Figur 2B ist ersichtlich, dass der frontseitiger Bereich 11 mit dem rückseitigen Bereich 13 verbindbar ausgestaltet ist. Aus den Figuren ist ferner ersichtlich, dass an dem frontseitigen Bereich 11 eine frontseitiger Abdeckung 14 vorgesehen ist. Aus Figur 2B ist ferner ersichtlich, dass die Leistungskontakte 40 mittels eines Befestigungsflansches 43 (siehe Figur 4B) mit dem rückseitigen Bereich 13 des Gehäuses 10 verbunden sind.

Der erfindungsgemäße Ladestecker weist ferner eine im Gehäuse 10 angeordnete Platine 20 auf, die zwischen den Leistungskontakten 40 und einem in dem frontseitigen Bereich 11 vorgesehenen Halteabschnitt 12 des Gehäuses 10 angeordnet ist. Dabei ist die Platine 20 mittels mehrerer zwischen dem Leistungskontakten 40 und dem Halteabschnitt 12 angeordneten Federkrafteinrichtungen 30 zwischen dem Leistungskontakt 40 und dem Halteabschnitt 12 verspannt. Im Genaueren sind die Federkrafteinrichtungen 30 zwischen dem Befestigungsflansch 43 und der Platine 20 angeordnet, sodass die Federkrafteinrichtungen 30 die Platine 20 in Richtung des Halteabschnitts 12 kraftbeaufschlagen, wodurch die schwimmend angeordnete Platine 20 zwischen dem Leistungskontakt und dem Halteabschnitt 12 verspannt ist.

Folglich ist die Platine 20 mit den jeweiligen Leistungskontakten 40 mittels der Federkrafteinrichtungen 30 thermisch gekoppelt und galvanisch verbunden. Denn die Federkrafteinrichtungen 30 sind vorzugsweise aus einem Federstahl gebildet, sodass bei Kontaktierung des Befestigungsflansches 43 mittels der Federkrafteinrichtungen 30 eine galvanische Verbindung zwischen der Federkrafteinrichtungen 30 und den jeweiligen Leistungskontakten 40 gebildet wird.

Die Federkrafteinrichtungen 30 sind dabei als oberflächenmontierte Federkrafteinrichtungen 30 ausgebildet, die auch als SMD-Federkrafteinrichtungen 30 bezeichnet werden, und mit Kontaktflächen 21 der Platine 20 verlötet. Folglich besteht eine galvanische Verbindung zwischen den jeweiligen Leistungskontakten 40 und den entsprechenden Kontaktflächen 21 der Platine 20.

In Figur 4C ist die Platine 20 in Alleinstellung dargestellt. Es ist ersichtlich, dass die Platine 20 zwei Durchgangsöffnungen 22 aufweist, durch die die jeweils ersten Anschlussbereiche 41 der Leistungskontakte 40 hindurchragen. Folglich ist eine radiale Positionierung der Platine 20 mittels der ersten Anschlussbereich 41 der Leistungskontakte 40 gewährleistet. Die Platine 20 weist, wie bereits oben erwähnt, metallisch ausgebildete Kontaktflächen 21 auf, die die Durchgangsöffnungen 22 jeweils umschließen. Auf jeder der Kontaktflächen 21 sind in Umfangsrichtung beabstandet drei Federkrafteinrichtungen 30 angeordnet und mit den jeweiligen Kontaktflächen 21 verlötet. In dem dargestellten Ausführungsbeispiel sind die Federkrafteinrichtungen 30 als mehrfach gebogene Federstahlbänder 30 ausgebildet. Zur Versorgung der Platine 20 mit Strom und zum Datenaustausch weist die Platine 20 mehrere elektrische Anschlüsse 23 auf.

Obschon aus den Zeichnungen nicht ersichtlich, weist die Platine 20 einen Temperatursensor auf, mittels dem die Temperatur der mit der Platine 20 gekoppelten Leistungskontakte 40 ermittelt werden kann. Vorzugsweise weist die Platine 20 eine der Anzahl der Durchgangsöffnungen 22 und damit eine der Anzahl der Leistungskontakte 40 entsprechende Anzahl von Temperatursensoren auf, sodass die Temperatur jedes Leistungskontakts 40 separat bestimmt werden kann.

Ferner weist die Platine 20 eine der Anzahl der Durchgangsöffnungen 22 und somit eine der Anzahl der in dem Ladestecker 1 verbauten Leistungskontakte 40 entsprechende Anzahl von Codierungsmittel auf, mittels denen eine Widerstandscodierung der jeweiligen Leistungskontakte 40 ermöglicht ist. Die Codierungsmittel sind dabei vorzugsweise als ohmsche Widerstände ausgebildet.

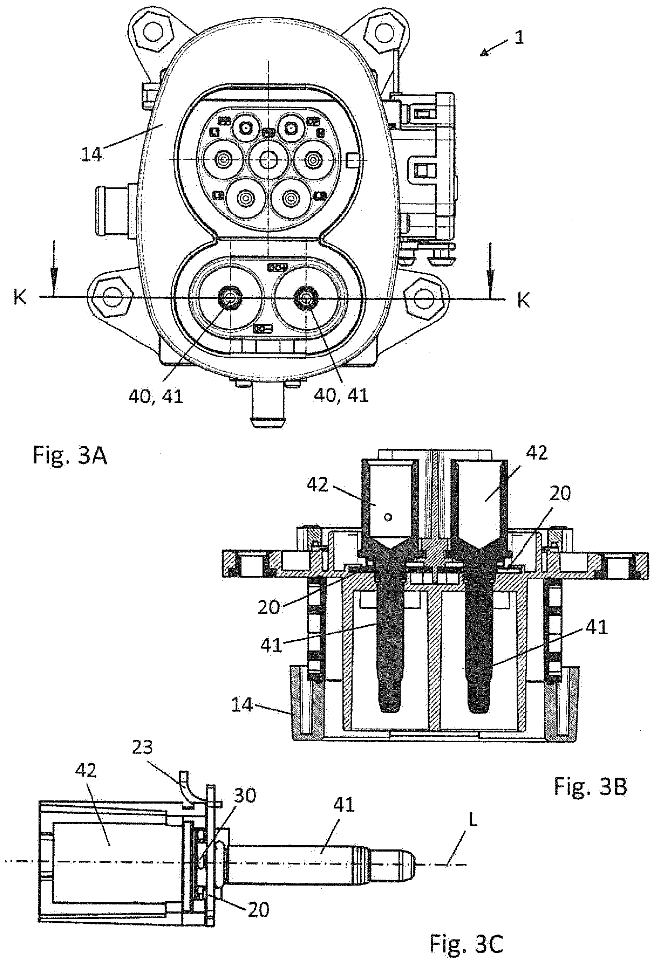

Aus den Figuren 2B, 2C, 3B, 3C, 4A und 4B ist ersichtlich, dass eine Flächennormale der Platine 20 im Wesentlichen parallel zu den jeweiligen Längsachsen L der Leistungskontakte 40 ausgerichtet sind.

### Bezugszeichenliste

- 1: Elektroanschlusseinrichtung / Ladestecker
- 10: Gehäuse / Ladesteckergehäuse
- 11: frontseitiger Bereich (des Gehäuses)
- 12: Halteabschnitt (des Gehäuses)
- 13: rückseitiger Bereich (des Gehäuses)
- 20: Platine
- 21: Kontaktfläche (der Platine)
- 22: Durchgangsöffnung (der Platine)
- 23: elektrischer Anschluss (der Platine)
- 30: Federkrafteinrichtung / Feder
- 40: Leistungskontakt
- 41: erster Anschlussbereich (des Leistungskontakts)
- 42: zweiter Anschlussbereich (des Leistungskontakts)
- 43: Befestigungsflansch (des Leistungskontakts)

- L: Längsachse (des Leistungskontakts) / Steckrichtung des Ladesteckers

## Patentansprüche

1. Elektroanschlusseinrichtung (1) zur Kopplung mit einer korrespondierenden Verbindungsvorrichtung und zur Übertragung elektrischer Energie, wobei die Elektroanschlusseinrichtung (1)
- zumindest einen in einem Gehäuse (10) der Elektroanschlusseinrichtung (1) angeordneten und mit diesem verbundenen Leistungskontakt (40),
- zumindest einen Temperatursensor zum Bestimmen einer Temperatur des Leistungskontakts (40) aufweist und
- eine in deren Gehäuse (10) angeordnete Platine (20) aufweist, die zwischen dem Leistungskontakt (40) und einem Halteabschnitt (12) des Gehäuses (10) angeordnet ist,
- und zumindest eine Federkrafteinrichtung (30) aufweist, wobei die Platine (20) mittels der zwischen dem Leistungskontakt (40) und dem Halteabschnitt (12) angeordneten Federkrafteinrichtung (30) zwischen dem Leistungskontakt (40) und dem Halteabschnitt (12) verspannt ist,
- wobei die Platine (20) mit dem Leistungskontakt (40) direkt oder über die Federkrafteinrichtung (30) thermisch gekoppelt ist, und
- wobei der zumindest eine Temperatursensor auf der Platine (20) angeordnet ist, wobei
- das Gehäuse (10) einen frontseitigen Bereich (11) und einen mit diesem verbindbaren rückseitigen Bereich (13) aufweist;
- wobei der Leistungskontakt (40) im rückseitigen Bereich (13) angeordnet und mit diesem verbunden ist;
- wobei der Halteabschnitt (12) des Gehäuses (10) im frontseitigen Bereich (11) angeordnet ist;
- wobei die Platine (20) zwischen dem rückseitigen Bereich (13) und dem frontseitigen Bereich (11) angeordnet ist; **dadurch gekennzeichnet, dass**
- die Federkrafteinrichtung (30) den Leistungskontakt (40) in eine zu einer Längsachse (L) des Leistungskontakts (40) parallelen Richtung kraftbeaufschlagt.

2. Elektroanschlusseinrichtung (1) nach Anspruch 1, **dadurch gekennzeichnet, dass** die Platine (20) mit dem Leistungskontakt (40) direkt oder über die Federkrafteinrichtung (30) galvanisch verbunden ist.

3. Elektroanschlusseinrichtung (1) nach Anspruch 1, **dadurch gekennzeichnet, dass** die Platine (20) eine elektrisch leitend ausgebildete Kontaktfläche (21) aufweist, die mit dem Leistungskontakt (40) direkt oder über die Federkrafteinrichtung (30) galvanisch verbunden ist.

4. Elektroanschlusseinrichtung (1) nach Anspruch 3, **dadurch gekennzeichnet, dass** die Federkrafteinrichtung (30) als oberflächenmontierte Federkrafteinrichtung (30) ausgebildet ist und mit der Kontaktfläche (21) verlötet ist.

5. Elektroanschlusseinrichtung (1) nach zumindest einem der Ansprüche 3 oder 4, **gekennzeichnet durch** die folgenden Merkmale:
- die Platine (20) weist eine Durchgangsöffnung (22) auf, durch die der Leistungskontakt (40) hindurchragt; und
- die Kontaktfläche (21) der Platine (20) umschließt deren Durchgangsöffnung (22).

6. Elektroanschlusseinrichtung (1) nach Anspruch 1, **gekennzeichnet durch** die folgenden Merkmale:
- die Federkrafteinrichtung (30) ist mit dem Leistungskontakt (40) und der Platine (20) galvanisch verbunden; und
- die Platine (20) ist mittels der Federkrafteinrichtung (30) gegen den Halteabschnitt (12) verspannt.

7. Elektroanschlusseinrichtung (1) nach einem der vorhergehenden Ansprüche, **gekennzeichnet durch** die folgenden Merkmale:
- der Leistungskontakt (40) weist einen Befestigungsflansch (43) auf, mittels dem der Leistungskontakt (40) mit dem Gehäuse (10) verbunden ist;
- der Befestigungsflansch (43) erstreckt sich radial von der Längsachse (L) des Leistungskontakts (40) weg.

8. Elektroanschlusseinrichtung (1) nach Anspruch 7, **dadurch gekennzeichnet, dass** die Federkrafteinrichtung (30) zwischen dem Befestigungsflansch (43) und dem Halteabschnitt (12) des Gehäuses (10) angeordnet ist.

9. Elektroanschlusseinrichtung (1) nach einem der vorhergehenden Ansprüche, **dadurch gekennzeichnet, dass** die Platine (20) zur Widerstandscodierung des Leistungskontakts (40) verwendet wird.

10. Elektroanschlusseinrichtung (1) nach einem der vorhergehenden Ansprüche, **dadurch gekennzeichnet, dass** eine Flächennormale der Platine (20) im Wesentlichen parallel zu der Längsachse (L) des Leistungskontakts (40) ausgerichtet ist.

11. Elektroanschlusseinrichtung (1) nach einem der vorhergehenden Ansprüche, **dadurch gekennzeichnet, dass** der Temperatursensor ein temperaturabhängiger elektrischer Widerstand, insbesondere ein Thermistor ist.

12. Ladestation zur Abgabe elektrischer Energie an einen Empfänger elektrischer Energie, **dadurch gekennzeichnet, dass** die Ladestation eine als Ladestecker (100) ausgebildete Elektroanschlusseinrichtung (1) nach einem der Ansprüche 1 bis 11 aufweist, die mit der Ladestation mittels eines Versorgungskabels elektrisch verbunden ist.

## Claims

1. An electrical connection apparatus (1) for coupling to a corresponding connecting device and for transmitting electrical energy, wherein the electrical connection apparatus (1) comprises
- at least one power contact (40) which is arranged in a housing (10) of the electrical connection apparatus (1) and is connected to said housing,
- at least one temperature sensor for determining a temperature of the power contact (40), and
- a printed circuit board (20) which is arranged in the housing (10) of said electrical connection apparatus and is arranged between the power contact (40) and a retaining section (12) of the housing (10),
- and at least one spring-force apparatus (30), wherein the printed circuit board (20) is clamped between the power contact (40) and the retaining section (12) by means of the spring-force apparatus (30) which is arranged between the power contact (40) and the retaining section (12),
- wherein the printed circuit board (20) is thermally coupled to the power contact (40) directly or by means of the spring-force apparatus (30), and
- wherein the at least one temperature sensor is arranged on the printed circuit board (20),
- wherein the housing (10) comprises a front region (11) and a back region (13) that can be connected thereto;
- wherein the power contact (40) is arranged in the back region (13) and is connected thereto;
- wherein the retaining section (12) of the housing (10) is arranged in the front region (11);
- wherein the printed circuit board (20) is arranged between the back region (13) and the front region (11); **characterized in that**
- the spring-force apparatus (30) applies force to the power contact (40) in a direction parallel to a longitudinal axis (L) of the power contact (40).

2. The electrical connection apparatus (1) according to claim 1, **characterized in that** the printed circuit board (20) is galvanically connected to the power contact (40) directly or by means of the spring-force apparatus (30).

3. The electrical connection apparatus (1) according to claim 1, **characterized in that** the printed circuit board (20) comprises a contact surface (21) which is in an electrically conductive form and which is galvanically connected to the power contact (40) directly or by means of the spring-force apparatus (30).

4. The electrical connection apparatus (1) according to claim 3, **characterized in that** the spring-force apparatus (30) is in the form of a surface-mounted spring-force apparatus (30) and is soldered to the contact surface (21).

5. The electrical connection apparatus (1) according to at least one of claims 3 or 4, **characterized by** the following features:
- the printed circuit board (20) comprises a through hole (22), through which the power contact (40) protrudes; and
- the contact surface (21) of the printed circuit board (20) surrounds the through hole (22) thereof.

6. The electrical connection apparatus (1) according to claim 1, **characterized by** the following features:
- the spring-force apparatus (30) is galvanically connected to the power contact (40) and the printed circuit board (20); and
- the printed circuit board (20) is clamped against the retaining section (12) by means of the spring-force apparatus (30).

7. The electrical connection apparatus (1) according to one of the preceding claims, **characterized by** the following features:
- the power contact (40) comprises a securing flange (43), by means of which the power contact (40) is connected to the housing (10);
- the securing flange (43) extends radially away from a longitudinal axis (L) of the power contact (40).

8. The electrical connection apparatus (1) according to claim 7, **characterized in that** the spring-force apparatus (30) is arranged between the securing flange (43) and the retaining section (12) of the housing (10).

9. The electrical connection apparatus (1) according to one of the preceding claims, **characterized in that** the printed circuit board (20) is used for the resistance coding of the power contact (40).

10. The electrical connection apparatus (1) according to one of the preceding claims, **characterized in that** a surface normal of the printed circuit board (20) is oriented substantially parallel to a longitudinal axis (L) of the power contact (40).

11. The electrical connection apparatus (1) according to one of the preceding claims, **characterized in that** the temperature sensor is a temperature-dependent electrical resistor, in particular a thermistor.

12. A charging station for delivering electrical energy to a receiver of electrical energy, **characterized in that** the charging station comprises an electrical connection apparatus (1) according to one of claims 1 to 11 in the form of a charging plug (100), which is electrically connected to the charging station by means of a supply cable.

## Revendications

1. Dispositif de connexion électrique (1) permettant le couplage à un mécanisme de liaison correspondant et permettant la transmission d'énergie électrique, le dispositif de connexion électrique (1)
- présentant au moins un contact de puissance (40) disposé dans un boîtier (10) du dispositif de connexion électrique (1) et relié à celui-ci,
- présentant au moins un capteur de température permettant de déterminer une température du contact de puissance (40) et
- présentant une carte de circuit imprimé (20) disposée dans le boîtier (10), laquelle carte de circuit imprimé est disposée entre le contact de puissance (40) et une section de maintien (12) du boîtier (10),
- et présentant au moins un dispositif à force élastique (30), la carte de circuit imprimé (20) étant serrée entre le contact de puissance (40) et la section de maintien (12) au moyen du dispositif à force élastique (30) disposé entre le contact de puissance (40) et la section de maintien (12),
- la carte de circuit imprimé (20) étant couplée thermiquement, directement ou par l'intermédiaire du dispositif à force élastique (30), au contact de puissance (40), et
- l'au moins un capteur de température étant disposé sur la carte de circuit imprimé (20),
- le boîtier (10) présentant une zone avant (11) et une zone arrière (13) pouvant être reliée à cette dernière ;
- le contact de puissance (40) étant disposé dans la zone arrière (13) et étant relié à celle-ci ;
- la section de maintien (12) du boîtier (10) étant disposée dans la zone avant (11) ;
- la carte de circuit imprimé (20) étant disposée entre la zone arrière (13) et la zone avant (11) ; **caractérisé en ce que**
- le dispositif à force élastique (30) sollicite par une force le contact de puissance (40) dans une direction parallèle à un axe longitudinal (L) du contact de puissance (40).

2. Dispositif de connexion électrique (1) selon la revendication 1, **caractérisé en ce que** la carte de circuit imprimé (20) est reliée galvaniquement, directement ou par l'intermédiaire du dispositif à force élastique (30), au contact de puissance (40).

3. Dispositif de connexion électrique (1) selon la revendication 1, **caractérisé en ce que** la carte de circuit imprimé (20) présente une surface de contact (21) électriquement conductrice qui est reliée galvaniquement, directement ou par l'intermédiaire du dispositif à force élastique (30), au contact de puissance (40).

4. Dispositif de connexion électrique (1) selon la revendication 3, **caractérisé en ce que** le dispositif à force élastique (30) est conçu comme un dispositif à force élastique monté en surface (30) et soudé à la surface de contact (21).

5. Dispositif de connexion électrique (1) selon au moins l'une des revendications 3 ou 4, **caractérisé par** les propriétés suivantes :
- la carte de circuit imprimé (20) présente une ouverture de passage (22) à travers laquelle le contact de puissance (40) fait saillie ; et
- la surface de contact (21) de la carte de circuit imprimé (20) entoure l'ouverture de passage (22) de cette dernière.

6. Dispositif de connexion électrique (1) selon la revendication 1, **caractérisé par** les propriétés suivantes :
- le dispositif à force élastique (30) est relié galvaniquement au contact de puissance (40) et à la carte de circuit imprimé (20) ; et
- la carte de circuit imprimé (20) est serrée contre la section de maintien (12) au moyen du dispositif à force élastique (30).

7. Dispositif de connexion électrique (1) selon l'une des revendications précédentes, **caractérisé par** les propriétés suivantes :
- le contact de puissance (40) présente une bride de fixation (43) au moyen de laquelle le contact de puissance (40) est relié au boîtier (10) ;
- la bride de fixation (43) s'étend radialement de façon à s'éloigner de l'axe longitudinal (L) du contact de puissance (40).

8. Dispositif de connexion électrique (1) selon la revendication 7, **caractérisé en ce que** le dispositif à force élastique (30) est disposé entre la bride de fixation (43) et la section de maintien (12) du boîtier (10).

9. Dispositif de connexion électrique (1) selon l'une des revendications précédentes, **caractérisé en ce que** la carte de circuit imprimé (20) est utilisée pour le codage de résistance du contact de puissance (40).

10. Dispositif de connexion électrique (1) selon l'une des revendications précédentes, **caractérisé en ce qu'**une normale à la surface de la carte de circuit imprimé (20) est orientée sensiblement parallèlement à l'axe longitudinal (L) du contact de puissance (40).

11. Dispositif de connexion électrique (1) selon l'une des revendications précédentes, **caractérisé en ce que** le capteur de température est une résistance électrique dépendant de la température, en particulier une thermistance.

12. Station de charge permettant la distribution d'énergie électrique à un récepteur d'énergie électrique, **caractérisée en ce que** la station de charge présente un dispositif de connexion électrique (1) conçu comme une prise de charge (100) selon l'une des revendications 1 à 11, lequel dispositif de connexion électrique est relié électriquement à la station de charge au moyen d'un câble d'alimentation.
